# EUROPEAN PATENT APPLICATION

(11) **EP 4 421 504 A1**
(43) Date of publication of application: **28.08.2024**
(21) Application number: 23158019.2
(22) Date of filing: 22.02.2023
(51) Int. Cl.: G01R 31/28, H05K 1/02

(54) **ARRANGEMENT FOR MONITORING THE CONDITION OF A POWER SEMICONDUCTOR MODULE OF AN ELECTRIC DRIVE DEVICE**

(71) Applicant: ABB SCHWEIZ AG, 5400 Baden (CH)
(72) Inventor: Kohvakka, Mikko, 00380 Helsinki (FI); Kovanen, Kari, 00380 Helsinki (FI); Hakkarainen, Henri, 00380 Helsinki (FI)
(74) Representative: Kolster Oy Ab

(57) **Abstract**

The present invention relates to the field of electric drive devices and arrangements comprising a plurality of power semiconductor components formed in or on a common substrate, and more particularly to an arrangement for monitoring the condition of a power semiconductor module of an electric drive device and an electric drive device. The arrangement for monitoring the condition of a power semiconductor module of an electric drive device comprises an at least one pair of sensor elements (11-16, 41-42, 51-52, 61-64, 71-76, 81-90) arranged on a printed circuit board parallel next to each other as sensor element pairs of PCB copper trace sensor elements, wherein every other PCB copper trace sensor element (11, 13, 15, 41, 51, 61, 63, 71, 73, 75, 81, 83, 85, 87, 89) of each sensor element pair is connected to a positive (UDC+) and every other PCB copper trace sensor element (12, 14, 15, 42, 52, 62, 64, 72, 74, 76, 82, 84, 86, 88, 90) of each sensor element pair is connected to a negative (UDC-) DC supply voltage source of said electric drive device, and wherein the DC supply voltage of said electric drive device is applied to said at least one pair of sensor elements (11-16, 41-42, 51-52, 61-64, 71-76, 81-90).

## Description

### FIELD OF THE INVENTION

The present invention relates to the field of electric drive devices and power semiconductor modules comprising one or more power semiconductor components formed in or on a common substrate, and more particularly to an arrangement for monitoring the condition of a power semiconductor module of an electric drive device and an electric drive device.

### BACKGROUND OF THE INVENTION

Electric drive devices i.e., electric drives, are used in industry for different applications, such as for driving motors within the transportation industry, for driving different devices within the process and manufacturing industry as well as within the energy industry. There are applications commonly used for electric drives within the transportation industry for example in metro and railway traffic applications as well as in ship propulsion unit applications of the marine industry. Within the process and manufacturing industry, electric drives can be used for example in conveyer applications, in mixer applications or even in paper machine applications. Within the energy industry, electric drives can be used for example as electric drives for wind turbines of the wind power industry.

Power semiconductors can be arranged into power semiconductor modules, such as, insulated gate bipolar transistor (IGBT) modules, which can include semiconductors configured into an inverter bridge leg or a whole inverter bridge.

The growth of dendrite and whiskers is one major failure mechanisms in power semiconductor modules causing short circuits in the main circuit and severe damages to the electric drive device. Dendritic growth usually occurs in a cathode surface as a metal formation starts to grow in the formation of tree-like structure, referred to as dendrites or in the formation of needle-like structure, referred to as whiskers. High voltage is a significant factor for boosting dendrite and whisker growth.

In the following, prior art will be described with reference to the accompanying figures, of which:
Figure 1 shows an exemplary illustration of dendrite growth in a substrate of one electric drive device according to the prior art.
Figure 2 shows an exemplary illustration of dendrite growth in a substrate of another electric drive device according to the prior art.
Figure 3 shows an exemplary illustration of dendrite growth in a substrate of a third electric drive device according to the prior art.

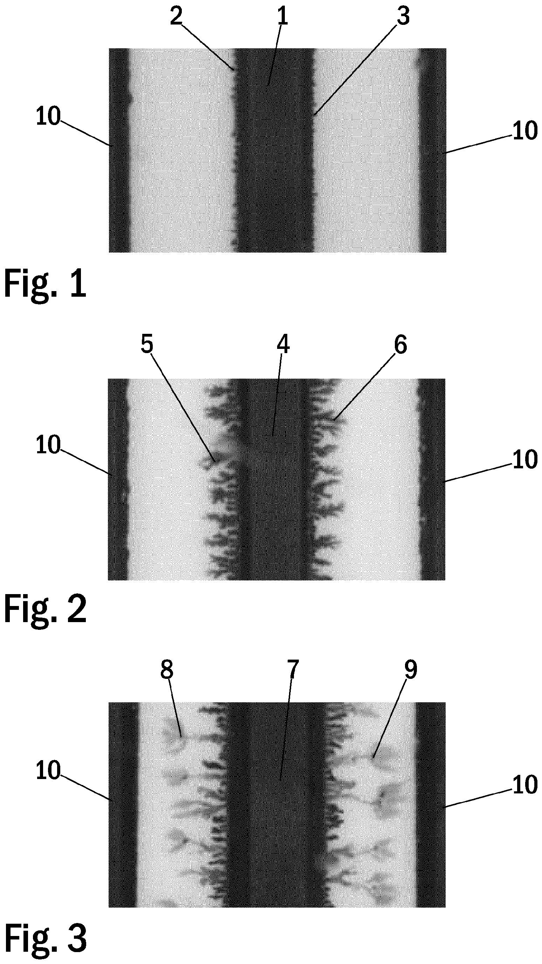

Figure 1 shows an exemplary illustration of dendrite growth in a substrate of one electric drive device according to the prior art. In the presented substrate a voltage of 15 V DC (DC, Direct Current) is applied between a cathode 1 in the center and the anodes 10 arranged in both sides of the cathode 1 for a certain test time period. The dendrites are indicated with reference numbers 2 and 3. In Figure 1 the dendrite growth is not very substantial.

Figure 2 shows an exemplary illustration of dendrite growth in a substrate of another electric drive device according to the prior art. In the presented substrate a voltage of 500 V DC is applied between a cathode 4 in the center and the anodes 10 arranged in both sides of the cathode 4 for a certain test time period. In exemplary illustration of Figure 2 the test time period is the same as in the illustration of Figure 1. Also the electric field and the relative humidity are the same as in the illustration of Figure 1.

In Figure 2 the dendrites are indicated with reference numbers 5 and 6. In Figure 2 the growth of the dendrites 5, 6 is substantial and much faster than in the illustration of Figure 1.

Figure 3 shows an exemplary illustration of dendrite growth in a substrate of a third electric drive device according to the prior art. In the presented substrate a voltage of 1000 V DC is applied between a cathode 7 in the center and the anodes 10 arranged in both sides of the cathode 7 for a certain test time period. In exemplary illustration of Figure 3 the test time period is the same as in the illustration of Figures 1 and 2. Also the electric field and the relative humidity are the same as in the illustration of Figures 1 and 2.

In Figure 3 the dendrites are indicated with reference numbers 8 and 9. In Figure 3 the growth of the dendrites 8, 9 is very rapid and even considerably faster than in the illustration of Figure 2. The conclusion drawn from the presented Figures 1 to 3 is that high voltage is a significant factor for boosting dendrite growth power semiconductor modules.

One popular solution of monitoring the condition of power semiconductor modules involves measuring dendrite growth and whisker growth by utilizing a conventional corrosion sensor based on thin copper traces. The sensor geometry of a conventional corrosion sensor does not allow high voltage, because the clearance between the copper traces of the conventional corrosion sensor is typically only about 0.1 mm. Many of the common failure mechanisms in the power semiconductor modules, such as e.g. gas related failure mechanisms in IGBT modules, are linked with a high voltage and therefore are not detectable with conventional corrosion sensors.

There is a demand in the market for an arrangement for monitoring the condition of a power semiconductor module that would provide a simple but effective solution for detecting risks for dendrite and whisker growth in main circuit components of a power semiconductor module.

### BRIEF DESCRIPTION OF THE INVENTION

The object of the invention is to introduce an arrangement for monitoring the condition of a power semiconductor module, which would provide a solution for detecting risks for dendrite and whisker growth in main circuit components of a power semiconductor module. Advantageous embodiments are furthermore presented.

It is brought forward a new arrangement for monitoring the condition of a power semiconductor module of an electric drive device, the arrangement comprising an at least one pair of sensor elements arranged on a printed circuit board parallel next to each other as sensor element pairs of PCB copper trace sensor elements, wherein every other PCB copper trace sensor element of each sensor element pair is connected to a positive DC supply voltage source of said electric drive device, and every other PCB copper trace sensor element of each sensor element pair is connected to a negative DC supply voltage source of said electric drive device, and wherein the DC supply voltage of said electric drive device is applied to said at least one pair of sensor elements.

In a preferred embodiment, said at least one pair of sensor elements consists of two pairs of sensor elements, said two sensor element pairs having a different clearance between the elements in said element pair.

In a preferred embodiment, said at least one pair of sensor elements consists of at least three pairs of sensor elements, at least two of said sensor element pairs having a different clearance between the elements in said element pair.

In a preferred embodiment, the PCB copper trace sensor elements of said at least one pair of sensor elements consist of 1 mm to 50 mm long PCB copper traces, preferably 3 mm to 30 mm long PCB copper traces, more preferably 5 mm to 15 mm long PCB copper traces.

In a preferred embodiment, the PCB copper trace sensor elements of said at least one pair of sensor elements do not have any coatings.

In a preferred embodiment, the UDC voltage is applied to said at least one pair of sensor elements at the same time as to the circuit components of the power semiconductor module.

In a preferred embodiment, said arrangement comprises detection electronics arranged to detect a voltage potential and/or a short circuit between said sensor elements.

In a preferred embodiment, said detection electronics comprises an at least one amplifier, an at least one voltage divider, an at least one voltage limiter, an at least one overvoltage protection and/or an at least one buffer isolator.

In a preferred embodiment, said every other PCB copper trace sensor element is connected to a positive DC supply voltage source and/or said every other PCB copper trace sensor element is connected to a negative DC supply voltage source of said electric drive device via a current limiter and/or an overcurrent protector.

In a preferred embodiment, wherein said printed circuit board is a small separate printed circuit board arranged on top of another printed circuit board.

In a preferred embodiment, said printed circuit board or said another printed circuit board is the printed circuit board of the electronic circuitry controlling the gate signalling of said power semiconductor module.

In a preferred embodiment, said printed circuit board or said another printed circuit board is arranged inside said power semiconductor module.

In a preferred embodiment, said printed circuit board and/or or said another printed circuit board comprises ceramic material and/or composite material.

In a preferred embodiment, said arrangement is arranged to perform condition monitoring activities based on said detected voltage potential and/or said detected short circuit between said sensor elements.

It is brought forward a new electric drive device comprising an arrangement for monitoring the condition of a power semiconductor module of an electric drive device, the arrangement comprising an at least one pair of sensor elements arranged on a printed circuit board parallel next to each other as sensor element pairs of PCB copper trace sensor elements, wherein every other PCB copper trace sensor element of each sensor element pair is connected to a positive DC supply voltage source of said electric drive device, and every other PCB copper trace sensor element of each sensor element pair is connected to a negative DC supply voltage source of said electric drive device, and wherein the DC supply voltage of said electric drive device is applied to said at least one pair of sensor elements.

### BRIEF DESCRIPTION OF THE DRAWINGS

In the following, the present invention will be described in more detail by way of example and with reference to the attached drawings, in which:
Figure 1 shows an exemplary illustration of dendrite growth in a substrate of one electric drive device according to the prior art.
Figure 2 shows an exemplary illustration of dendrite growth in a substrate of another electric drive device according to the prior art.
Figure 3 shows an exemplary illustration of dendrite growth in a substrate of a third electric drive device according to the prior art.

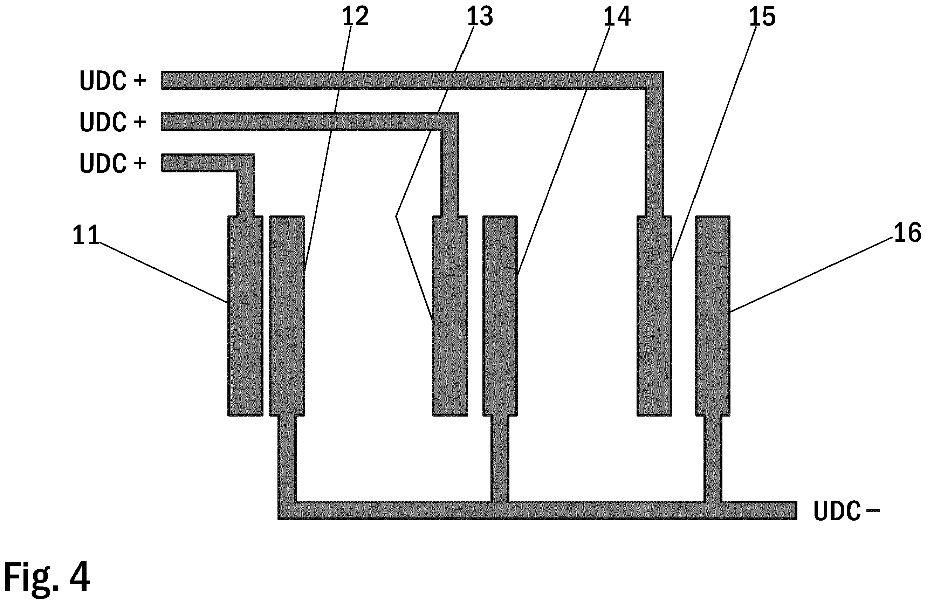

Figure 4 illustrates sensor elements of one embodiment of an arrangement for monitoring the condition of a power semiconductor module according to the present invention.

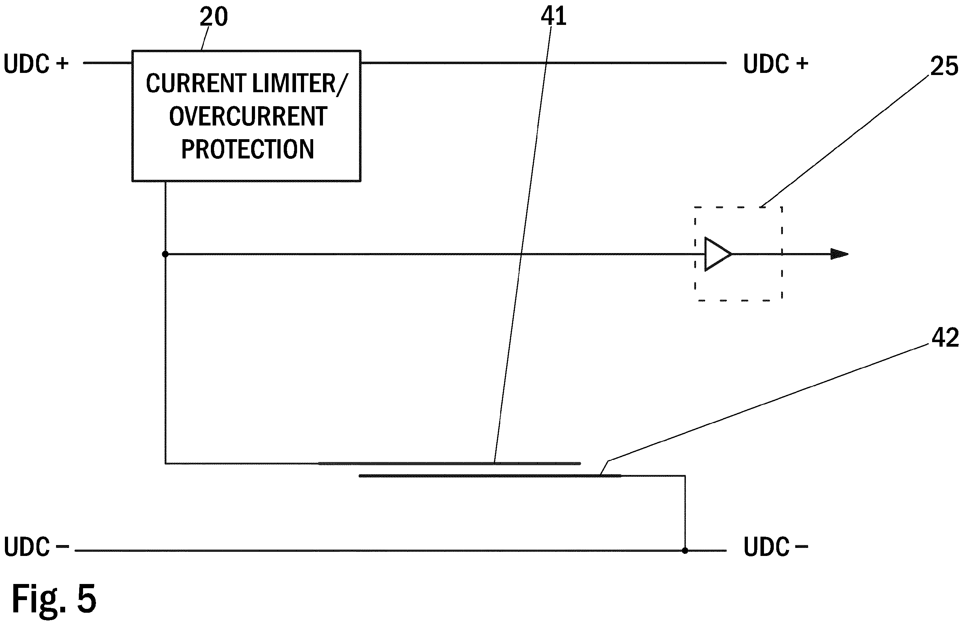

Figure 5 illustrates a simplified diagram of one embodiment of an arrangement for monitoring the condition of a power semiconductor module according to the present invention.

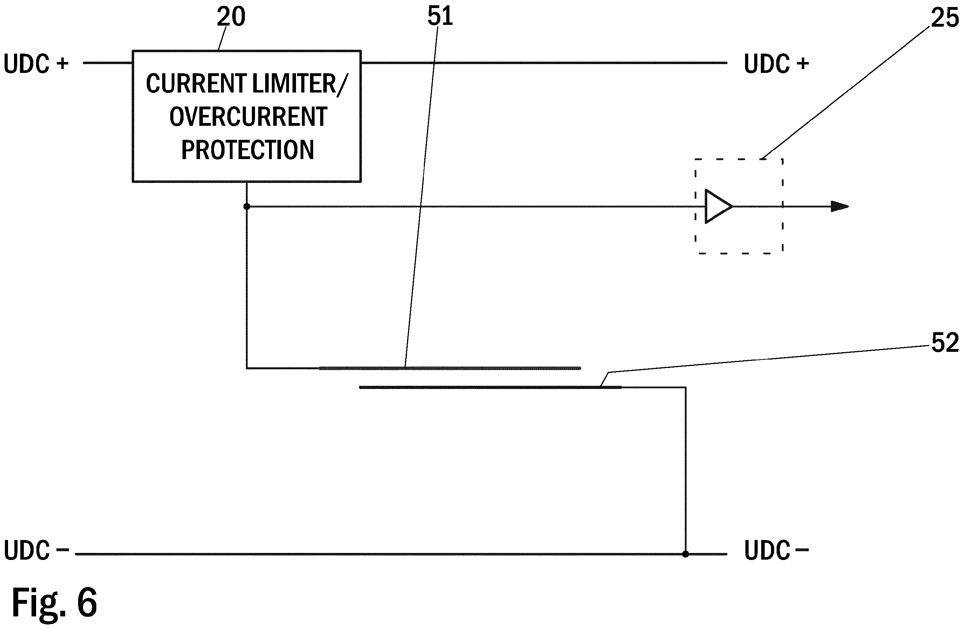

Figure 6 illustrates a simplified diagram of another embodiment of an arrangement for monitoring the condition of a power semiconductor module according to the present invention.

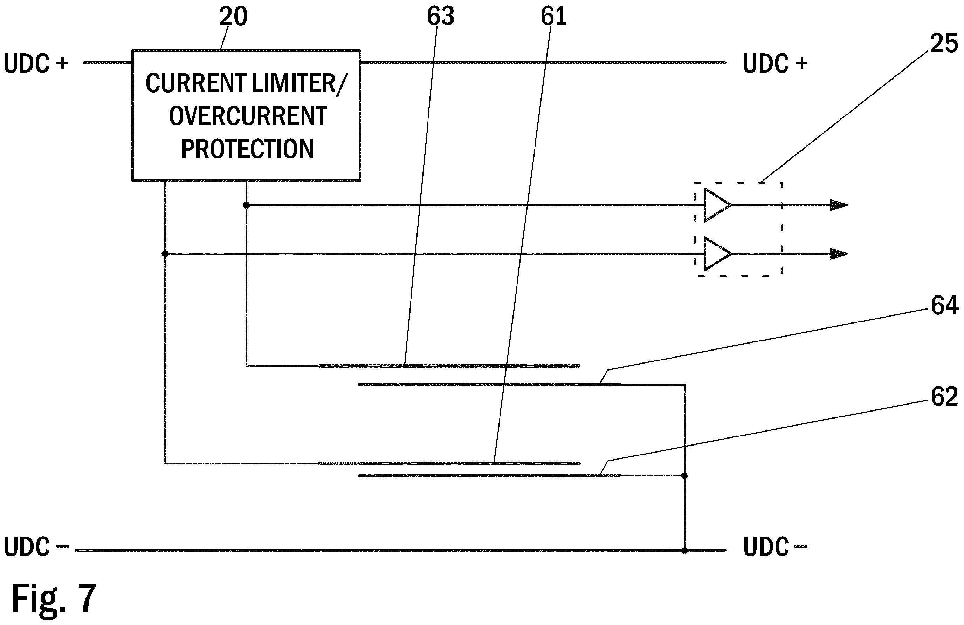

Figure 7 illustrates a simplified diagram of a third embodiment of an arrangement for monitoring the condition of a power semiconductor module according to the present invention.

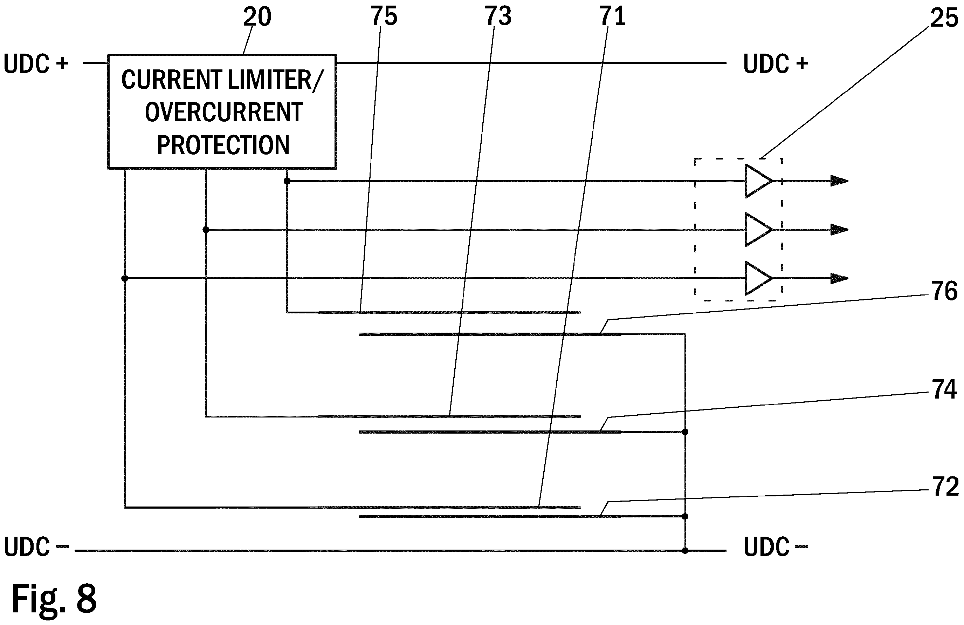

Figure 8 illustrates a simplified diagram of a fourth embodiment of an arrangement for monitoring the condition of a power semiconductor module according to the present invention.

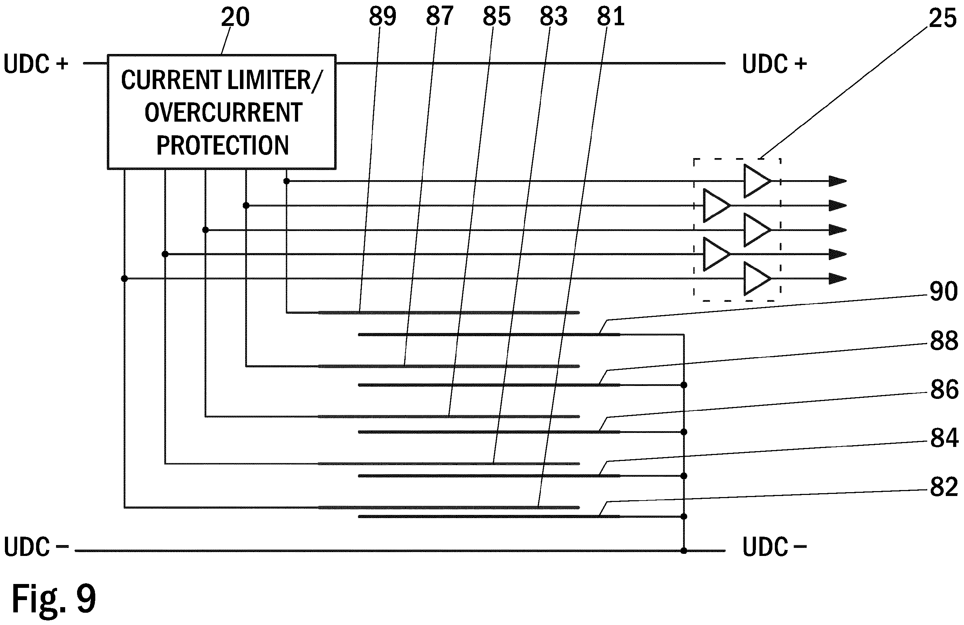

Figure 9 illustrates a simplified diagram of a fifth embodiment of an arrangement for monitoring the condition of a power semiconductor module according to the present invention.

The foregoing aspects, features and advantages of the invention will be apparent from the drawings and the detailed description related thereto.

The prior art drawings of Figures 1 to 3 have been presented earlier. In the following, the invention will be described in greater detail by means of preferred embodiments with reference to the accompanying drawings of Figures 4 to 9.

### DETAILED DESCRIPTION

The following embodiments are exemplary. Although the description may refer to "an", "one", or "some" embodiment(s) in several locations, this does not necessarily mean that each such reference is to the same embodiment(s), or that the feature only applies to a single embodiment, for example. Single features of different embodiments may also be combined to provide other embodiments. Generally, all terms and expressions used should be interpreted broadly and they are intended to illustrate, not to restrict, the embodiments. The figures only show components necessary for understanding the various embodiments. The number and/or shape of the various elements, and generally their implementation, could vary from the examples shown in the figures. The application of the various embodiments described herein is not limited to any specific system, but it can be used in connection with various electric drive devices and power semiconductor modules therefor.

The arrangement for monitoring the condition of a power semiconductor module according to one embodiment of the present invention comprises an at least one pair of sensor elements arranged on a printed circuit board parallel next to each other as sensor element pairs of PCB copper trace sensor elements, wherein every other PCB copper trace sensor element of each sensor element pair is connected to a positive DC supply voltage source of said electric drive device, and every other PCB copper trace sensor element of each sensor element pair is connected to a negative DC supply voltage source of said electric drive device, and wherein the DC supply voltage of said electric drive device is applied to said at least one pair of sensor elements.

Figure 4 illustrates sensor elements of one embodiment of an arrangement for monitoring the condition of a power semiconductor module according to the present invention. In the present embodiment, sensor elements 11-16 are trace sensor elements of PCB conductive material, e.g. PCB copper trace sensor elements 11-16 (PCB, Printed Circuit Board). In the present embodiment, said sensor elements 11-16 consist of short, for example 1 mm to 50 mm long PCB copper traces, preferably 3 mm to 30 mm long PCB copper traces, more preferably 5 mm to 15 mm long PCB copper traces.

When referring to "PCB copper" and to a "PCB copper trace sensor element", in this application it is meant to comprise any material used as a layer of conductive material in printed circuit boards and any sensor elements manufactured to form a trace of said material in a printed circuit board. Said PCB copper trace sensor elements may also be tin coated PCB copper trace sensor elements. When referring to "printed circuit board", in this application is meant to comprise any substrate for a printed circuit board, this including substrates comprising ceramic material and/or composite material. Suitable ceramic materials may include e.g. aluminium oxide (Al₂O₃), aluminium nitride (AIN) and silicon nitride (Si₃N₄). Suitable composite material may include e.g. epoxy resins and glass epoxy laminates, such as FR-4 grade fiberglass with a flame-resistant epoxy resin binder.

In the present embodiment, the PCB copper traces 11-16 of said sensor elements 11-16 are arranged parallel next to each other in sensor element pairs 11-12, 13-14 and 15-16, where every other PCB copper trace 11, 13, 15 is connected to a positive DC supply voltage source UDC+ of said electric drive device, e.g. to a plus busbar UDC+ of the supply voltage of the intermediate circuit, i.e. of DC Bus or of DC Link. Respectively, every other PCB copper trace 12, 14, 16 is connected to a negative DC supply voltage source UDC- of said electric drive device, e.g. to a minus busbar UDC- of the supply voltage of the intermediate circuit. In the present embodiment, there is a high voltage potential difference between the PCB copper traces of said in sensor element pairs 11-12, 13-14 and 15-16.

In the present embodiment of figure 4 in a first sensor element pair 11-12 the clearance is the smallest between the PCB copper trace 11 connected to plus busbar UDC+ and the PCB copper trace 12 connected to minus busbar UDC. In a second sensor element pair 13-14 the clearance between the PCB copper traces 13 and 14 is bigger than in said first sensor element pair 11-12. Respectively, in a third sensor element pair 15-16 the clearance between the PCB copper traces 15 and 16 is bigger than in said first sensor element pair 11-12 and bigger than in said second sensor element pair 13-14. There are multiple sensor element pairs 11-12, 13-14 and 15-16 with parallel traces 11-12, 13-14, 15-16 next to each other and the distance between traces 11-12, 13-14 and 15-16 is increased. The PCB copper traces 11-16 of said sensor elements 11-16 do not have any coatings, which may protect the victim element and slow down the detection process.

In the present embodiment, a high DC voltage potential is applied across the PCB copper traces of said PCB copper trace sensor elements 11-16, which ensure that the same phenomenon happens both in said PCB copper trace sensor elements 11-16, and in the main circuits components of said power semiconductor module.

As dendrites or whiskers grow, short circuits will appear between the PCB copper traces 11-16 of said sensor elements 11-16. First, a short circuit happens on a first sensor element pair 11-12 where the clearance is the smallest. Next, a short circuit happens on a second sensor element pair 13-14 having a second smallest clearance. Finally a short circuit happens on a third sensor element pair 15-16 having a biggest clearance.

In the present embodiment, a high DC voltage potential is applied across the PCB copper traces of said PCB copper trace sensor elements 11-16, which ensure that the same phenomenon happens both in said PCB copper trace sensor elements 11-16, and in the main circuits components of said power semiconductor module.

In the present embodiment, said PCB copper trace sensor elements 11-16 are arranged to react faster than main circuits components of said power semiconductor module that are vulnerable for dendrites and whiskers.

Figure 5 illustrates a simplified diagram of one embodiment of an arrangement for monitoring the condition of a power semiconductor module according to the present invention. In the present embodiment, one sensor element pair 41, 42 of PCB conductive material, e.g. PCB copper trace sensor element pair 41, 42 is arranged so that the PCB copper traces 41, 42 of said sensor elements 41, 42 are arranged parallel next to each other so that one PCB copper trace 41 is connected to a positive DC supply voltage source UDC+ of said electric drive device, e.g. to a plus busbar UDC+ of the supply voltage of the intermediate circuit, i.e. of DC Bus or of DC Link. Respectively, the other PCB copper trace 42 is connected to a negative DC supply voltage source UDC-of said electric drive device, e.g. to a minus busbar UDC- of the supply voltage of the intermediate circuit. In the present embodiment, there is a high voltage potential difference between the PCB copper traces of said in sensor element pairs 41, 42.

As dendrites or whiskers grow, short circuits will appear between the PCB copper traces 41, 42 of said sensor elements 41, 42. In the present embodiment the PCB copper trace sensor element 41 is connected to a positive DC supply voltage source UDC+ of said electric drive device via a current limiter and/or an overcurrent protector 20. In other embodiment the PCB copper trace sensor element 42 may be connected to a negative DC supply voltage source UDC- of said electric drive device via a current limiter and/or an overcurrent protector. Said current limiter and/or overcurrent protector 20 may be any arrangement configured to limit the current and/or protect for an overcurrent. Said current limiter and/or overcurrent protector 20 may comprise one or more resistors and/or one or more fuses. Said current limiter and/or overcurrent protector 20 limits the short circuit current so that it does not cause any impact on the main circuit. The present embodiment comprises detection electronics arranged to detect a voltage potential and/or a short circuit between said sensor elements 41, 42. Said detection electronics 25 may comprise an at least one amplifier, an at least one voltage divider, an at least one voltage limiter, an at least one overvoltage protection and/or an at least one buffer isolator. In the present embodiment the detection electronics 25 is indicated by a dashed line.

In the present embodiment, the clearance between the said sensor elements 41, 42 is small in comparison to clearances in the circuit components of the power semiconductor module. This allows said sensor elements 41, 42 to rapidly detect the growth of dendrites and/or whiskers developing in the environment of the circuit components of the power semiconductor module at an early stage. This gives a plenty of time for planning of maintenance activities in electric drive device installations where an early detection is needed.

Figure 6 illustrates a simplified diagram of another embodiment of an arrangement for monitoring the condition of a power semiconductor module according to the present invention. In the present another embodiment, one sensor element pair 51, 52 of PCB conductive material, e.g. PCB copper trace sensor element pair 51, 52 is arranged so that the PCB copper traces 51, 52 of said sensor elements 51, 52 are arranged parallel next to each other so that one PCB copper trace 51 is connected to a positive DC supply voltage source UDC+ of said electric drive device, e.g. to a plus busbar UDC+ of the supply voltage of the intermediate circuit, i.e. of DC Bus or of DC Link. Respectively, the other PCB copper trace 52 is connected to a negative DC supply voltage source UDC-of said electric drive device, e.g. to a minus busbar UDC- of the supply voltage of the intermediate circuit. In the present another embodiment, there is a high voltage potential difference between the PCB copper traces of said in sensor element pairs 51, 52.

As dendrites or whiskers grow, short circuits will appear between the PCB copper traces 51, 52 of said sensor elements 51, 52. In the present another embodiment the PCB copper trace sensor element 51 is connected to a positive DC supply voltage source UDC+ of said electric drive device via a current limiter and/or an overcurrent protector 20. In other embodiment the PCB copper trace sensor element 52 may be connected to a negative DC supply voltage source UDC- of said electric drive device via a current limiter and/or an overcurrent protector. Said current limiter and/or overcurrent protector 20 may comprise one or more resistors and/or one or more fuses. Said current limiter and/or overcurrent protector 20 limits the short circuit current so that it does not cause any impact on the main circuit. The present embodiment comprises detection electronics arranged to detect a voltage potential and/or a short circuit between said sensor elements 51, 52. Said detection electronics 25 may comprise an at least one amplifier, an at least one voltage divider, an at least one voltage limiter, an at least one overvoltage protection and/or an at least one buffer isolator. In the present embodiment the detection electronics 25 is indicated by a dashed line.

In the present another embodiment, the clearance between the said sensor elements 51, 52 is similar in comparison to clearances in the circuit components of the power semiconductor module. This allows said sensor elements 51, 52 to rapidly detect the growth of dendrites and/or whiskers at a stage in which said dendrites and/or whiskers have already grown. This gives a prompt warning for maintenance activities in electric drive device installations where a later stage detection is adequate.

Figure 7 illustrates a simplified diagram of a third embodiment of an arrangement for monitoring the condition of a power semiconductor module according to the present invention. In the present third embodiment, two sensor element pairs 61-62, 63-64 of PCB conductive material, e.g. PCB copper trace sensor element pairs 61-62, 63-64 are arranged as a first sensor element pair 61-62 and a second sensor element pair 63-64. In said sensor element pairs 61 - 62, 63-64 the PCB copper traces 61-64 of said sensor elements are arranged parallel next to each other so that one PCB copper trace 61, 63 of each sensor pair 61-62, 63-64 is connected to a positive DC supply voltage source UDC+ of said electric drive device, e.g. to a plus busbar UDC+ of the supply voltage of the intermediate circuit, i.e. of DC Bus or of DC Link. Respectively, the other PCB copper trace 62, 64 of each sensor pair 61-62, 63-64 is connected to a negative DC supply voltage source UDC- of said electric drive device, e.g. to a minus busbar UDC- of the supply voltage of the intermediate circuit. In the present third embodiment, there is a high voltage potential difference between the PCB copper traces of said in sensor element pairs 61-62, 63-64. In the present third embodiment the PCB copper traces 61, 63 of each sensor pair 61-62, 63-64 are connected to a positive DC supply voltage source UDC+ of said electric drive device via a current limiter and/or an overcurrent protector 20. In other embodiment the PCB copper traces 62, 64 of each sensor pair 61-62, 63-64 may be connected to a negative DC supply voltage source UDC- of said electric drive device via a current limiter and/or an overcurrent protector. The short circuit current is limited by a current limiter and/or an overcurrent protector 20. In the present third embodiment the detection electronics is indicated by an amplifier symbol, a dashed line and a reference number 25.

In the present third embodiment, the clearance between the first sensor elements 61, 62 is small in comparison to clearances in the circuit components of the power semiconductor module. This allows said sensor elements 61, 62 to rapidly detect the growth of dendrites and/or whiskers at an early stage. This gives a plenty of time for planning of maintenance activities in electric drive device installations when this is required. Also in the present third embodiment, the clearance between the second sensor elements 63, 64 is similar in comparison to clearances in the circuit components of the power semiconductor module. This gives a prompt warning for maintenance activities in electric drive device installations when this is required.

Figure 8 illustrates a simplified diagram of a fourth embodiment of an arrangement for monitoring the condition of a power semiconductor module according to the present invention. In the present fourth embodiment, three sensor element pairs 71-72, 73-74, 75-76 of PCB conductive material, e.g. PCB copper trace sensor element pairs 71-72, 73-74, 75-76 are arranged as a first sensor element pair 71-72, a second sensor element pair 73-74 and a third sensor element pair 75-76. In said sensor element pairs 71-72, 73-74, 75-76 the PCB copper traces 71-76 of said sensor elements are arranged parallel next to each other so that one PCB copper trace 71, 73, 75 of each sensor pair 71-72, 73-74, 75-76 is connected to a positive DC supply voltage source UDC+ of said electric drive device, e.g. to a plus busbar UDC+ of the supply voltage of the intermediate circuit, i.e. of DC Bus or of DC Link. Respectively, the other PCB copper trace 72, 74, 76 of each sensor pair 71-72, 73-74, 75-76 is connected to a negative DC supply voltage source UDC- of said electric drive device, e.g. to a minus busbar UDC- of the supply voltage of the intermediate circuit. In the present fourth embodiment, there is a high voltage potential difference between the PCB copper traces of said in sensor element pairs 71-72, 73-74, 75-76. In the present fourth embodiment the PCB copper traces 71, 73, 75 of each sensor pair 71-72, 73-74, 75-76 are connected to a positive DC supply voltage source UDC+ of said electric drive device via a current limiter and/or an overcurrent protector 20. In other embodiment the PCB copper traces 72, 74, 76 of each sensor pair 71-72, 73-74, 75-76 may be connected to a negative DC supply voltage source UDC- of said electric drive device via a current limiter and/or an overcurrent protector. The short circuit current is limited by a current limiter and/or an overcurrent protector 20. In the present fourth embodiment the detection electronics is indicated by an amplifier symbol, a dashed line and a reference number 25.

In the present fourth embodiment, the clearance between the first sensor elements 71-72 is small in comparison to clearances in the circuit components of the power semiconductor module. This allows said sensor elements 71-72 to rapidly detect the growth of dendrites and/or whiskers at an early stage. This gives a plenty of time for planning of maintenance activities in electric drive device installations when this is required. Also in the present fourth embodiment, the clearance between the third sensor elements 75-76 is similar in comparison to clearances in the circuit components of the power semiconductor module. This allows said sensor elements 75-76 to rapidly detect the growth of dendrites and/or whiskers at a stage in which said dendrites and/or whiskers have already grown. This gives a prompt warning for maintenance activities in electric drive device installations when this is required.

Figure 9 illustrates a simplified diagram of a fifth embodiment of an arrangement for monitoring the condition of a power semiconductor module according to the present invention. In the present fifth embodiment, five sensor element pairs 81-82, 83-84, 85-86, 87-88, 89-90 of PCB conductive material, e.g. PCB copper trace sensor element pairs 81-82, 83-84, 85-86, 87-88, 89-90 are arranged as a first sensor element pair 81-82, a second sensor element pair 83-84, a third sensor element pair 85-86, a fourth sensor element pair 87-88 and a fifth sensor element pair 89-90. In said sensor element pairs 81-82, 83-84, 85-86, 87-88, 89-90 the PCB copper traces 81-90 of said sensor elements are arranged parallel next to each other so that one PCB copper trace 81, 83, 85, 87, 89 of each sensor pair 81-82, 83-84, 85-86, 87-88, 89-90 is connected to a positive DC supply voltage source UDC+ of said electric drive device, e.g. to a plus busbar UDC+ of the supply voltage of the intermediate circuit, i.e. of DC Bus or of DC Link. Respectively, the other PCB copper trace 82, 84, 86, 88, 90 of each sensor pair 81-82, 83-84, 85-86, 87-88, 89-90 is connected to a negative DC supply voltage source UDC- of said electric drive device, e.g. to a minus busbar UDC- of the supply voltage of the intermediate circuit. In the present fifth embodiment, there is a high voltage potential difference between the PCB copper traces of said in sensor element pairs 81-82, 83-84, 85-86, 87-88, 89-90. In the present fifth embodiment the PCB copper traces 81, 83, 85, 87, 89 of each sensor pair 81-82, 83-84, 85-86, 87-88, 89-90 are connected to a positive DC supply voltage source UDC+ of said electric drive device via a current limiter and/or an overcurrent protector 20. In other embodiment the PCB copper traces 82, 84, 86, 88, 90 of each sensor pair 81-82, 83-84, 85-86, 87-88, 89-90 may be connected to a negative DC supply voltage source UDC- of said electric drive device via a current limiter and/or an overcurrent protector. The short circuit current is limited by a current limiter and/or an overcurrent protector 20. In the present fifth embodiment the detection electronics is indicated by an amplifier symbol, a dashed line and a reference number 25.

In the present fifth embodiment, the clearance between the first sensor elements 81-82 or between the second sensor elements 83-84 small in comparison to clearances in the circuit components of the power semiconductor module. This allows said sensor elements 81-84 to rapidly detect the growth of dendrites and/or whiskers at an early stage. This gives a plenty of time for planning of maintenance activities in electric drive device installations when this is required. Also in the present fifth embodiment, the clearance between the fourth sensor elements 87-88 or between the fifth sensor elements 89-90 is similar in comparison to clearances in the circuit components of the power semiconductor module. This allows said sensor elements 87-90 to rapidly detect the growth of dendrites and/or whiskers at a stage in which said dendrites and/or whiskers have already grown. This gives a prompt warning for maintenance activities in electric drive device installations when this is required.

In an embodiment of the present invention, the UDC voltage is applied to said sensor elements simultaneously with, i.e. at the same time as to the main circuit components of the power semiconductor module. This makes sure that also the electrical field is applied said sensor elements simultaneously with, i.e. at the same time as to the main circuit components of the power semiconductor module.

In an embodiment of the present invention, said arrangement may be arranged to perform condition monitoring activities based on said detected voltage potential and/or said detected short circuit between said sensor elements. Said condition monitoring activities may include one or more of maintenance planning, maintenance activities, component replacements, product replacements and other service activities.

In an embodiment of the present invention, said at least one pair of sensor elements may be arranged on the printed circuit board of the electronic circuitry controlling the gate signalling of said power semiconductor module, e.g. of the gate driver or of the gate adapter. In another embodiment of the present invention, said at least one pair of sensor elements may be arranged on a small separate printed circuit board, said a separate printed circuit board arranged on the top of another printed circuit board. Said another printed circuit board may be the printed circuit board of the electronic circuitry controlling the gate signalling of said power semiconductor module, e.g. of the gate driver or of the gate adapter. In the gate driver and in the gate adapter board the UDC potentials are present, and the operation conditions are very similar to the operation environment of the power semiconductor module, e.g. air flow, humidity, gas concentration. In another embodiment of the present invention, said printed circuit board or said another printed circuit board is arranged inside said power semiconductor module. In an embodiment of the present invention, said at least one pair of sensor elements may be biased by UDC voltage that is used with main circuit components of the power semiconductor module. This makes sure that the electrical field is applied to the sensor element exactly the same time than in main circuit components of the power semiconductor module that is vulnerable for dendrites and whiskers. In another embodiment of the present invention, said printed circuit board and/or said another printed circuit board comprises ceramic material and/or composite material. Suitable ceramic materials may include e.g. aluminium oxide (Al₂O₃), aluminium nitride (AIN) and silicon nitride (Si₃N₄). Suitable composite material may include e.g. epoxy resins and glass epoxy laminates, such as FR-4 grade fiberglass with a flame-resistant epoxy resin binder.

With the help of the solution for monitoring the condition of a power semiconductor module according to the present invention there is provided a simple but effective method for detecting dendrite and whisker growth and give early warning to user allowing predictive maintenance. The presented arrangement for monitoring the condition of a power semiconductor module according to the present invention comprises a set of PCB copper trace sensor element pairs and simple detection electronics. The presented arrangement for monitoring the condition of a power semiconductor module according to the present invention is very elegant, straightforward, and inexpensive.

In the present invention an at least one pair of PCB copper trace sensor elements is/are utilized which PCB copper trace sensor elements react faster than main circuits components that are vulnerable for dendrites and whiskers. In the present invention a high DC voltage potential is applied across the PCB copper trace sensor elements, which ensure that the same phenomenon happens in the sensor element and in the main circuit components.

With the help of the present invention there is provided a solution for monitoring the condition of a power semiconductor module and for planning the maintenance actions. As dendrites or whiskers grow, short circuits will appear between the PCB copper traces of sensor elements. First, a short circuit happens on sensor element pairs where the clearance is the smallest this providing an indication for planning the maintenance. Thereafter, short circuits happen on other sensor element pair having a bigger clearance providing warnings for maintenance activities.

The present invention provides clear indication of the risk that a phenomenon similar to what is happening on sensor element pairs will happen in actual power semiconductor module. As the power semiconductor modules typically have protective gel or other protection to gas, the phenomenom is somewhat slower in power semiconductor modules. The sensor element pairs according to the present invention react faster which makes it possible to perform maintenance activities before the power semiconductor modules fail.

With the help of the solution according to the present invention an arrangement for monitoring the condition of a power semiconductor module is introduced, which provides a solution for tackling dendrite and whisker growth in main circuit components of a power semiconductor module. The solution according to the present invention provides predictive condition monitoring and early warnings on coming failures and a more reliable electric drive device. The solution according to the present invention provides savings in planning, in service, in maintenance and in operation.

The solution according to the present invention provides an effective and elegant solution for identifying risks for failures due to dendrite and whisker growth in main circuit components of a power semiconductor module.

It is to be understood that the above description and the accompanying Figures are only intended to teach the best way known to the inventors to make and use the invention. It will be apparent to a person skilled in the art that the inventive concept can be implemented in various ways. The above-described embodiments of the invention may thus be modified or varied, without departing from the invention, as appreciated by those skilled in the art in light of the above teachings. It is therefore to be understood that the invention and its embodiments are not limited to the examples described above but may vary within the scope of the claims and their equivalents.

## Claims

1. An arrangement for monitoring the condition of a power semiconductor module of an electric drive device, the arrangement comprising:
- an at least one pair of sensor elements (11-16, 41-42, 51-52, 61-64, 71-76, 81-90) arranged on a printed circuit board parallel next to each other as sensor element pairs of PCB copper trace sensor elements,
- wherein every other PCB copper trace sensor element (11, 13, 15, 41, 51, 61, 63, 71, 73, 75, 81, 83, 85, 87, 89) of each sensor element pair is connected to a positive DC supply voltage source (UDC+) of said electric drive device, and every other PCB copper trace sensor element (12, 14, 15, 42, 52, 62, 64, 72, 74, 76, 82, 84, 86, 88, 90) of each sensor element pair is connected to a negative DC supply voltage source (UDC-) of said electric drive device, and
- wherein the DC supply voltage of said electric drive device is applied to said at least one pair of sensor elements (11-16, 41-42, 51-52, 61-64, 71-76, 81-90).

2. An arrangement according to claim 1, wherein said at least one pair of sensor elements (61-64) consists of two pairs of sensor elements (61-64), said two sensor element pairs (61-64) having a different clearance between the elements in said element pair.

3. An arrangement according to claim 1, wherein said at least one pair of sensor elements (11-16, 71-76, 81-90) consists of at least three pairs of sensor elements (11-16, 71-76, 81-90), at least two of said sensor element pairs (11-16, 71-76, 81-90) having a different clearance between the elements in said element pair.

4. An arrangement according to any of the claims 1-3, wherein the PCB copper trace sensor elements of said at least one pair of sensor elements (11-16, 41-42, 51-52, 61-64, 71-76, 81-90) consist of 1 mm to 50 mm long PCB copper traces, preferably 3 mm to 30 mm long PCB copper traces, more preferably 5 mm to 15 mm long PCB copper traces.

5. An arrangement according to any of the claims 1-4, wherein the PCB copper trace sensor elements of said at least one pair of sensor elements (11-16, 41-42, 51-52, 61-64, 71-76, 81-90) do not have any coatings.

6. An arrangement according to any of the claims 1-5, wherein the UDC voltage is applied to said at least one pair of sensor elements (11-16, 41-42, 51-52, 61-64, 71-76, 81-90) at the same time as to the circuit components of the power semiconductor module.

7. An arrangement according to any of the claims 1-6, wherein said arrangement comprises detection electronics (25) arranged to detect a voltage potential and/or a short circuit between said sensor elements (11-16, 41-42, 51-52, 61-64, 71-76, 81-90).

8. An arrangement according to claim 7, wherein said detection electronics (25) comprises an at least one amplifier, an at least one voltage divider, an at least one voltage limiter, an at least one overvoltage protection and/or an at least one buffer isolator.

9. An arrangement according to any of the claims 1-8, wherein said every other PCB copper trace sensor element (11, 13, 15, 41, 51, 61, 63, 71, 73, 75, 81, 83, 85, 87, 89) is connected to a positive DC supply voltage source (UDC+) and/or said every other PCB copper trace sensor element (12, 14, 16, 42, 52, 62, 64, 72, 74, 76, 82, 84, 86, 88, 90) is connected to a negative DC supply voltage source (UDC-) of said electric drive device via a current limiter and/or an overcurrent protector (20).

10. An arrangement according to any of the claims 1-9, wherein said printed circuit board is a small separate printed circuit board arranged on top of another printed circuit board.

11. An arrangement according to any of the claims 1-10, wherein said printed circuit board or said another printed circuit board is the printed circuit board of the electronic circuitry controlling the gate signalling of said power semiconductor module.

12. An arrangement according to any of the claims 1-10, wherein said printed circuit board or said another printed circuit board is arranged inside said power semiconductor module.

13. An arrangement according to any of the claims 1-11, wherein said printed circuit board and/or or said another printed circuit board comprises ceramic material and/or composite material.

14. An arrangement according to any of the claims 7-13, wherein said arrangement is arranged to perform condition monitoring activities based on said detected voltage potential and/or said detected short circuit between said sensor elements (11-16, 41-42, 51-52, 61-64, 71-76, 81-90).

15. An electric drive device comprising an arrangement according to any of the claims 1-14.
